# EUROPEAN PATENT APPLICATION

(11) **EP 1 717 876 A1**
(43) Date of publication of application: **02.11.2006**
(21) Application number: 05405320.2
(22) Date of filing: 27.04.2005
(51) Int. Cl.: H01L 51/44

(54) **Interconnect in polymer light-emitting or light-detecting devices or solar cells**

(71) Applicant: C.S.E.M. CENTRE SUISSE D'ELECTRONIQUE ET DE MICROTECHNIQUE SA, 2007 Neuchâtel (CH)
(72) Inventor: Kiy, Michael, 8400 Wintetrthur (CH)
(74) Representative: Schneider Feldmann AG Patent- und Markenanwälte

(57) **Abstract**

In the method for manufacturing an optoelectronic polymer device (1), a first conductive layer (3) is deposited on a substrate (2). The first conductive layer (3) is structured such that an inner island (32) defining an optically active area (10) and an outer island (31) electrically isolated from the inner island (32) are formed. An optically active polymer layer (4) is deposited by spin-coating on the first conductive layer (3) such that a feedthrough area (6) in an edge region of the substrate (2) remains free of the optically active polymer layer (4). A second conductive layer (5) is deposited on the optically active polymer layer (4). An electric contact between the outer island (32) and the second conductive layer (5) is formed in the feedthrough area (6). Thanks to this contact, the second conductive layer (5) can easily be contacted (73) from outside.

## Description

### FIELD OF THE INVENTION

The present invention relates to polymer light-emitting or light-detecting devices or solar cells. It teaches a simple electrical connection of two conducting electrodes separated by a spin-coated polymer layer. More specifically, the invention relates to an optoelectronic polymer device with an optically active area and to a method for manufacturing the same, according to the preambles of the independent claims.

### BACKGROUND OF THE INVENTION

Thin-film light-emitting, light-detecting devices and solar cells based on solution-processed polymers have been described in various publications. The totality of all these devices is called "optoelectronic polymer devices" throughout this document. A typical optoelectronic polymer device is based on an optically active polymer layer and, but not compulsory, charge-injection and/or charge-transport layers. This layer or these layers are sandwiched between two electrical contact layers (electrodes). At least one of the contact layers is transparent to transmit the light from or to the optically active layer.

Bradley et al. teach in WO-90/13148 that polymers can be used as light-emitting materials. Figure 1 of WO-90/13148 gives a few examples of typical materials employed in the prior art in optoelectronic polymer devices.

In the paper "Solid-state light emitting devices based on the tris-chelated Ruthenium(II) complex 4.-high efficiency light-emitting devices based on derivates of the - 3 -tris (2,2'-bipyridyl) Ruthenium(II) (Ru(bpy)3) complex", Journal of the American Chemical Society, 124, 4918, 2002, Rudmann et al. describe a highly efficient light-emitting device based on electrochemical cells. An example of a light-emitting electrochemical cell is a conjugated polymer blended with a solid electrolyte that provides mobile ions.

Photodiodes based on polymer materials are described by S. Karg, W. Riess, V. Dyakonov, M. Schwoerer, Synth. Metals 54, 427 (1993); H. Antoniadis, B. R. Hsieh, M. A. Abkowitz, S. A. Jenekhe, M. Stolka, Synth. Metals 64, 265 (1994); D. D. C. Bradley, R. H. Friend, A. B. Holmes, J. Condens. Matter 6, 1379 (1994), R. H. Friend, A. B. Homes, D. D. C. Bradley, R. N. Marks, U.S. Patent No. 5,523,555 (1996).

Polymer solar cells are reviewed by H. Hoppe, N. S. Sariciftci in Journal of Materials Research, 19, 1924 (2004).

R. H. Friend et al. review in Nature 397, 121, 1999 optoelectronic devices based on polymers.

The devices are usually based on a substrate with one electrode layer, and one or several active layers are deposited onto the electrode layer. A second electrode on top defines the sandwich structure. Patterning of the electrodes defines the device region.

The polymers can be deposited by solution-compatible thin-film deposition processes such as spin-coating, ink-jet printing or the doctor-blade technique. For simple and fast polymer deposition of continuous polymer films, spin-coating is the most often used technology. A glass plate or a plastic foil is usually used as a substrate.

After spin-coating, the substrate is usually covered by a continuous thin film of the polymer. The second electrode on top is usually fully separated from the first electrode on the substrate by the spin-coated polymer film.

For many applications, such as serial connection of several polymer light-emitting diodes for solid-state lighting, electrical interconnections of the electrodes are necessary. One solution of the known art is to pattern the polymer layer with printing methods, such as ink-jet printing. Another approach is the removal of areas of the polymer film by ablation techniques or scratching. Both technological processes are more complicated than the spin-coating alone, and therefore the production speed is reduced.

### SUMMARY OF THE INVENTION

It is therefore an object of this invention to provide a more simple solution for interconnecting the individual electrode layers in order to obtain integrated circuits. In particular, it is an object to provide a simple and cheap optoelectronic polymer device and a method for simply and cheaply manufacturing an optoelectronic polymer device.

These and other objects are solved by the method and the device defined in the independent claims. Preferred embodiments of the invention are given in the dependent claims.

The device is designed in such a way that all the necessary interconnects are on the edge of the substrate. In case of spin-coated polymer films, the substrate edges are not covered perfectly, allowing therefore an electrical connection of the two electrode layers at the edges.

Thus, the method for manufacturing an optoelectronic polymer device with an optically active area comprises the steps of providing a substrate, and forming a sandwich structure on a surface of the substrate, the sandwich structure comprising an optically active polymer layer deposited by the spin-coating technique and sandwiched between a first conductive layer and a second conductive layer. The optically active polymer layer is deposited such that a feedthrough area in an edge region of the substrate remains free of the optically active polymer layer. An electric contact between the first conductive layer and the second conductive layer is formed in the feedthrough area, and on the first conductive layer or on the second conductive layer, the feedthrough area is electrically isolated from the optically active area.

The optoelectronic polymer device with an optically active area, comprises a substrate, and a sandwich structure on a surface of the substrate, the sandwich structure comprising an optically active polymer layer deposited by the spin-coating technique and sandwiched between a first conductive layer and a second conductive layer. The first conductive layer and the second conductive layer are contacted to each other in a feedthrough area located in an edge region of the substrate, and on the first conductive layer or on the second conductive layer, the feedthrough area is electrically isolated from the optically active area.

The device according to the invention can be used as a light-emitting device, a light-detecting device and/or a solar cell.

### BRIEF DESCRIPTION OF THE DRAWINGS

Embodiments of the invention are described in greater detail hereinafter relative to the attached schematic drawings.
- Figure 1: shows top views of a first embodiment the device according to the invention for three different steps of its manufacturing process.
- Figure 2: shows a cross section through the device according to the invention, along line II-II in Fig. 1(c).
- Figures 3 and 4: (a) further embodiments of the device according to the invention in top views, and (b) corresponding electric-circuit analogies.

### DESCRIPTION OF PREFERRED EMBODIMENTS

One embodiment of an optoelectronic polymer device is a top-emitting light-emitting diode (LED). In the following, the invention will be discussed with the help of this example, which, however, is not limiting.

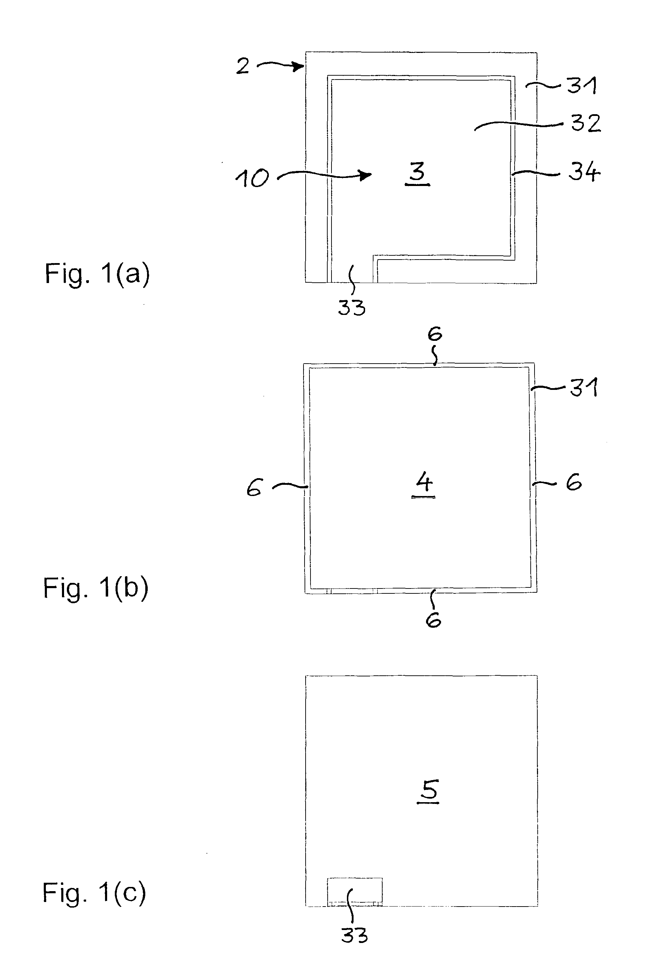

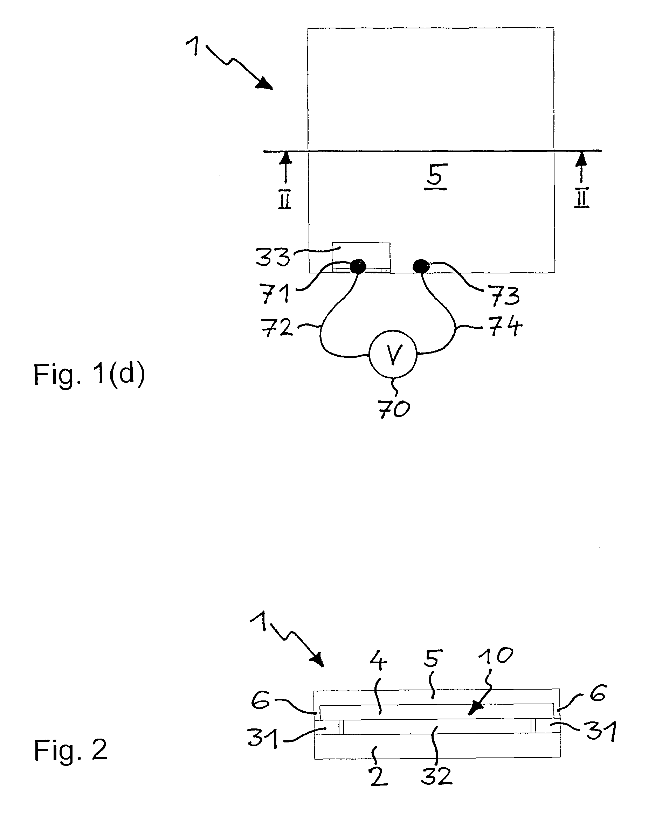

**Figure 1** shows, in top views, three stages of the manufacturing process of such a top-emitting LED. A substrate 2 (not shown alone) is provided, e.g., a quadratic glass plate with a side length of 50 mm.

One plane surface of the substrate 2 is covered with a first conductive layer 3 for providing a first electrode, e.g., an anode electrode capable of injecting holes into an organic semiconductor. The first conductive layer 3 may be a metal layer, e.g., a 100-nm thick aluminum layer or a 100-nm thick silver layer; alternatively, other conductive materials such as indium tin oxide (ITO) can be used. The first conductive layer 3 is patterned, e.g., in the way shown in **Figure 1(a)**. The patterning forms two islands 31, 32 electrically isolated from each other, e.g. , by a stripe-like gap 34 with a width of 1 mm. An outer island 31 of the first conductive layer 3 covers mainly the substrate 2 along its edges. An inner island 32 will define an active area 10 of the resulting optoelectronic polymer device 1 and serves as the anode in case of a light-emitting device. Only a small part of the inner island 32 reaches the substrate edge in order to serve as an electrical contact area 33 in the encapsulated device 1. The pattern can be created by several methods, such as evaporation through shadow masks, lift-off, laser ablation, scratching, or chemical etching.

To improve hole transport and injection properties, the first conductive layer 3 can optionally be covered by a suitable hole-transporting layer (not shown) such as a 45-nm thick layer of poly(3,4-ethylenedioxythiophene):poly(styrene-sulfonate) (PEDOT:PSS), Baytron P AL4083 from H. C. Starck GmbH. The hole-transporting layer may be deposited by spin-coating at approximately 3000 rpm. If the conductivity of the hole-transporting layer is not too high, it is not necessary to correspondingly pattern the hole-transporting layer, since its conduction across the 1-mm wide gap 34 is negligible.

In a next step, shown in **Figure 1(b)**, a light-emitting polymer material 4 is spin-coated almost over the whole area of the device, except for a stripe 6 along the substrate edges. It is known in the art that with the spin-coating technique, a stripe 6 with a width of 0.2-2 mm along the substrate edges remains uncoated, without taking any special measures. The polymer material 4 may be a mix of poly(N-vinyl carbazole) (PVK, 61%): 2-(4-biphenylyl)-5-(4-tert-butylphenyl)-1,3,4-oxadiazole (PBD, 24%): Tris(2-(4-tolyl)phenylpyridine)iridium (Ir(mppy)3, 6%): N,N'-diphenyl-N,N'-(bis(3-methylphenyl)-[1,1-biphenyl]-4,4'-diamine (TPD, 9%), as described by X. H. Yang and D. Neher in Applied Physics Letters Volume 84, Number 14, page 2476-2478 (2004), with a thickness of 80 nm.

The low-lying layers 3, 4 are then covered with a second conductive layer 5 for providing a second electrode, e.g., a cathode electrode that is capable of injecting electrons into the polymer material 4. The second conductive layer 5 may consist of a 5-nm thick barium layer capped by a very thin aluminum layer. The layer thicknesses given in this document refer to a certain preferred embodiment and are not limiting; the thicknesses of the conductive layers 3, 5 should for instance be adapted to the light-emitting polymer material 4 used and to other parameters. To improve electron transport and injection properties of the second conductive layer, an additional electron-transporting layer (not shown) can be deposited under the second conductive layer 5. Since the device discussed here is a top-emitting device, which means that light is not transmitted through the substrate 2, the second conductive layer 5 must be transparent for the light emitted by the polymer material 4.

The second conductive layer 5 (and, if present, the electron-transport layer) is patterned such that it covers the whole area of the device, except of the electrical contact area 33 of the anode 32 at the edge of the substrate 2, as shown in **Figure 1(c).**

The device of Figure 1(c) can be electrically contacted by two electric lines 72, 74, as shown in **Figure 1(d)**. Contacts 71, 73 may be formed by an appropriate technique known in the art, such as soldering or binding. An anode contact 71 is formed on the uncovered portion 33 of the inner island 32. A cathode contact 73 is formed near an edge of the device 1. The forming of the cathode contact 73 would be a problem in the prior art, since the second conductive layer 5 is very thin (typically 10-30 nm) and thus could not be contacted by any standard method; an additional reinforcement layer would have to be deposited for providing a sufficiently thick and robust contact area. This disadvantage is overcome by the present invention: even if the second conductive layer 5 is destroyed during the forming of the cathode contact 73, there is no disadvantageous effect since the outer island 31 of the first conductive layer 3 will be contacted, which is again in electric contact with the cathode 5 (cf. Fig. 2). By means of appropriate voltage-generating means 70 and the electric lines 72, 74, a voltage of, e.g., 5-10 V can be applied to the anode 32 and the cathode 5, and thus to the polymer material 4, for operating the device 1. The device 1 may be encapsulated, e.g., by gluing a glass plate onto the active device area with an epoxy, such as Araldit® Rapid.

**Figure 2** shows a cross section through the middle of the device 1 of Fig. 1(d), along line II-II. Due to the lack of polymer material 4 at the substrate edges, the second conductive layer 5 is electrically connected to the outer island 32 of the first conductive layer 3. Thus, the substrate edges form a feedthrough area 6 between the outer island 32 of the first conductive layer 3 and the second conductive layer 5.

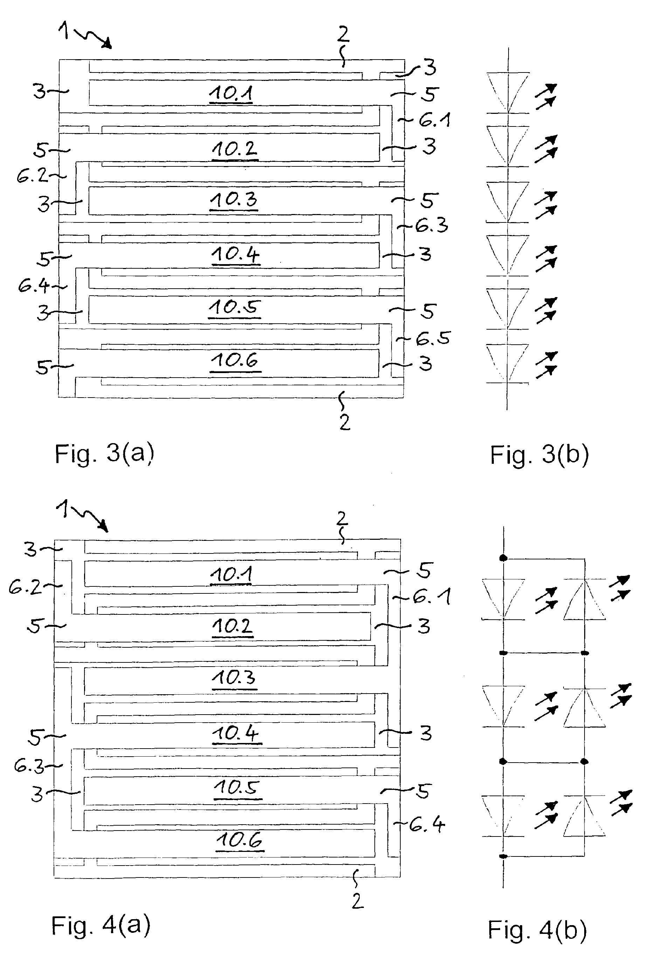

Another embodiment of the device 1 according to the invention is shown in a top view in **Figure 3(a)**. In this schematic representation, only the substrate 2, the first conductive layer 3 and the second conductive layer 5 are shown. The polymer layer 4 (cf. Fig. 2) lies between the first 3 and the second 5 conductive layer, but is not shown (or is transparent) in this representation for the sake of clarity. The embodiment of Fig. 3 uses the described interconnection technique in order to form an integrated circuit such as a serial connection of several optically active areas 10.1-10.6. An application of such a serial connection is the voltage multiplication of solar cells or of plane light-emitting diodes. A polymer light-emitting device 1 connected in such a way can be designed for direct plug into a power socket of 110 V or 220 V. The open-circuit voltage can be increased by serial connection of several solar cells or photodiodes. The embodiment of Fig. 3 comprises a plurality, e.g., six, of active areas 10.1-10.6. In each case, two neighboring active areas 10.1, 10.2 are connected in series. The first 3 and second 5 conductive layers are electrically contacted via feedthrough areas 6.1-6.5 in the left-hand and right-hand edge regions of the substrate. The contact in a feedthrough area 6.1 connects two neighboring active areas 10.1, 10.2 with each other. The fabrication obeys the above-described example of a large device, but more complicated patterns of the conductive layers 3, 5 are involved.

An electrical circuit equivalent to an electrode pattern with a serial connection of six diodes 10.1-10.6 (light emitting or light detecting) is shown in **Figure 3(b).**

A device 1 according to the invention with more advanced serial connection for AC applications is shown in the top view of **Figure 4(a)** and in the circuit diagram of **Figure 4(b)**. Three active areas 10.1, 10.3, 10.5 and three active areas 10.2, 10.4, 10.6 are in each case connected in series with opposite polarities.

This invention is not limited to the preferred embodiments described above, to which variations and improvements may be made, without departing from the scope of protection of the present patent.

### LIST OF REFERENCE SIGNS

- 1: Device
- 10: Optically active area

- 2: Substrate

- 3: First conductive layer
- 31: Outer island
- 32: Inner island
- 33: Contact area
- 34: Gap

- 4: Optically active polymer

- 5: Second conductive layer

- 6: Feedthrough area

- 70: Voltage generator
- 71, 73: Contacts
- 72, 74: Electric lines

## Claims

1. A method for manufacturing an optoelectronic polymer device (1) with an optically active area (10), comprising the steps of:
providing a substrate (2), and
forming a sandwich structure on a surface of the substrate (2), the sandwich structure comprising an optically active polymer layer (4) deposited by the spin-coating technique and sandwiched between a first conductive layer (3) and a second conductive layer (5),
**characterized in that**
the optically active polymer layer (4) is deposited such that a feedthrough area (6) in an edge region of the substrate remains free of the optically active polymer layer (4),
an electric contact between the first conductive layer and the second conductive layer is formed in the feedthrough area (6), and
on the first conductive layer (3) or on the second conductive layer (5), the feedthrough area (6) is electrically isolated from the optically active area (10).

2. The method according to claim 1, wherein an electric contact (73) for the second conductive layer (5) is provided in the feedthrough area (6).

3. The method according to any of the preceding claims, wherein a contact area (33) that is localized in an edge region of the substrate (2) and electrically isolated from the feedthrough area (6), remains free of the second conductive layer (5).

4. The method according to claim 3, wherein an electric contact (71) for the first conductive layer (3) is provided in the contact area (33).

5. The method according to any of the preceding claims, wherein the deposition of the first (3) and/or the second (5) conductive layer comprises sputtering a metal layer such as an aluminum or a silver layer.

6. The method according to any of the preceding claims, wherein between the first (3) and/or second (5) conductive layer and the optically active polymer layer (4), a hole-transporting layer and/or an electron-transporting layer is deposited.

7. The method according to any of the preceding claims, wherein a plurality of active areas (10.1-10.6) electrically isolated from each other and a plurality of feedthrough areas (6.1-6.5) electrically isolated from each other is provided.

8. An optoelectronic polymer device (1) with an optically active area (10), comprising:
a substrate (2), and
a sandwich structure on a surface of the substrate (2), the sandwich structure comprising an optically active polymer layer (4) deposited by the spin-coating technique and sandwiched between a first conductive layer (3) and a second conductive layer (5),
**characterized in that**
the first conductive layer (3) and the second conductive layer (5) are contacted to each other in a feedthrough area (6) located in an edge region of the substrate (2), and
on the first conductive layer (3) or on the second conductive layer (5), the feedthrough area (6) is electrically isolated from the optically active area (10).

9. The device (1) according to claim 8, wherein an electric contact (73) for the second conductive layer (5) is provided in the feedthrough area (6).

10. The device (1) according to claim 8 or 9, wherein a contact area (33) that is localized in an edge region of the substrate (2) and electrically isolated from the feedthrough area (6), is free of the second conductive layer (5).

11. The device (1) according to claim 10, wherein an electric contact (71) for the first conductive layer (3) is provided in the contact area (33).

12. The device (1) according to any of the claims 9-11, wherein the first (3) and/or the second (5) conductive layer comprises a metal layer such as an aluminum or a silver layer, or an indium-tin-oxide layer.

13. The device (1) according to any of the claims 9-12, wherein between the first (3) and/or second (5) conductive layer and the optically active polymer layer (4), a hole-transporting layer and/or an electron-transporting layer is provided.

14. The device (1) according to any of the preceding claims, wherein a plurality of active areas (10.1-10.6) electrically isolated from each other and a plurality of feedthrough areas (6.1-6.5) electrically isolated from each other is provided.

15. The device (1) according to claim 14, wherein the first (3) and/or the second (5) conductive layer is structured such that at least two of the active areas (10.1, 10.2) are connected in series by a contact in a feedthrough area (6.1).

16. The device (1) according to claim 14 or 15, wherein the first (3) and/or the second (5) conductive layer is structured such that at least two of the active areas (10.1, 10.3) are connected in parallel by a contact in the first (3) or second (5) conductive layer.

17. Use of the device (1) according to any of the claims 9-16 as a light-emitting device, a light-detecting device and/or a solar cell.
